# EUROPEAN PATENT APPLICATION

(11) **EP 2 840 609 A2**
(43) Date of publication of application: **25.02.2015**
(21) Application number: 14178268.0
(22) Date of filing: 24.07.2014
(51) Int. Cl.: H01L 27/092, H01L 27/105

(54) **High voltage power control system**

(30) Priority: 19.08.2013 US 201361867566 P
(71) Applicant: eMemory Technology Inc., Hsin-Chu 30075 (TW)
(72) Inventor: Yang, Ching-Sung, 300 Hsinchu City (TW); Kuo, Tung-Cheng, 300 Hsinchu City (TW)
(74) Representative: Becker Kurig Straus

(57) **Abstract**

A high voltage power control system (100, 300) comprises a microcontroller unit (110), an embedded non-volatile memory (120), and a high voltage driver (130). The micro controller unit (110) is configured to control high voltage outputs (132) of the high voltage power control system (100, 300). The embedded non-volatile memory (120) is electrically connected to the micro controller (110). The high voltage driver (130) is electrically connected to the micro controller (110) and is configured to output the high voltage outputs (132) of the high voltage power control system (100, 300). The high voltage power control system (100, 300) is compatible with a logic process while the embedded non-volatile memory (120) and the high voltage power control system (100, 300) can still support operations of high voltage.

## Description

### Field of the Invention

The invention relates to a high voltage power control system, and more particularly, a high voltage power control system compatible with a logic process.

### Background of the Invention

Multipoint Control Units (MCU(s)) used for high voltage power control have been adopted in many different applications such as in digital power management or touch panel control. Since the MCU is originally designed for logical signal control, the voltage level of the inputs and outputs of the MCU are mostly between 1.2V and 5V. Therefore, the MCU may require a high voltage device to sustain high voltage inputs and outputs between 5V and 18V. The different voltage requirements for the MCU and the high voltage device make it difficult to manufacture the MCU and the high voltage device with a same logic process. Namely, the MCU is manufactured by the logic process while the high voltage device is manufactured by a high voltage process.

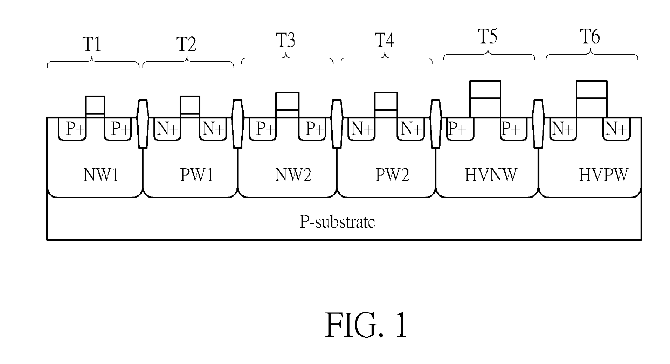

The high voltage process can be used to manufacture devices supporting low, medium and high voltage. FIG. 1 shows transistors T1 to T6 manufactured by the high voltage process. The transistors T1 and T2 are for low voltage devices supporting 1.2V, 1.5V or 1.8V, and the transistors T3 and T4 are for medium voltage devices supporting 3.3V or 5V. The transistors T5 and T6 are for high voltage devices supporting over 10V. To endure high voltage operations, the thicknesses of the gate oxide of transistors T5 and T6 are greater than the thicknesses of a gate oxide of the transistors T1 to T4 as shown in FIG. 1. For example, the thickness of the gate oxide of transistors T5 and T6 may be 250Å while the thickness of the gate oxide of transistors T3 and T4 may be 70Å or 130Å depending on the supporting voltage, and the thickness of the gate oxide of transistors T1 and T2 may be less than 50Å. In addition, the high voltage N-well HVNW used by the transistor T5 has a lower doping concentration than the N-wells NW1 and NW2 used by the transistors T1 and T3. The high voltage P-well HVPW used for the transistor T6 also has a lower doping concentration than the P-wells PW1 and PW2 used by the transistors T2 and T4. Moreover, the high voltage process needs even more masks and procedures than the logic process needs. Consequently, the extra high voltage process not only increases the manufacturing cost but also makes the integration more difficult.

### Summary of the Invention

One embodiment of the present invention discloses a high voltage power control system compatible with a logic process. The high voltage power control system comprises a microcontroller unit, an embedded non-volatile memory, and a high voltage driver. The micro controller unit is configured to control high voltage outputs of the high voltage power control system and comprises at least low voltage devices. The embedded non-volatile memory is electrically connected to the micro controller, and comprises low voltage devices, medium voltage devices and laterally diffused transistors. The high voltage driver is electrically connected to the micro controller and is configured to output the high voltage outputs of the high voltage power control system. The high voltage driver at least comprises medium voltage devices and laterally diffused transistors. The high voltage power control system is compatible with a logic process.

In another embodiment of the present invention, the high voltage power control system further comprises an adjustable high voltage pumping circuit. The adjustable high voltage pumping circuit is configured to provide/supply power to the high voltage driver, and comprises at least medium voltage devices and laterally diffused transistors.

### Brief Description of the Drawings

In the following, the invention is further illustrated by way of example, taking reference to the accompanying drawing. Thereof:
FIG. 1 shows transistors manufactured by a high voltage process according to prior art,
FIG. 2 shows a high voltage power control system according to one embodiment of the present invention,
FIG. 3 shows a laterally diffused transistor structure according to one embodiment of the present invention, and
FIG. 4 shows a high voltage power control system according to another embodiment of the present invention.

### Detailed Description

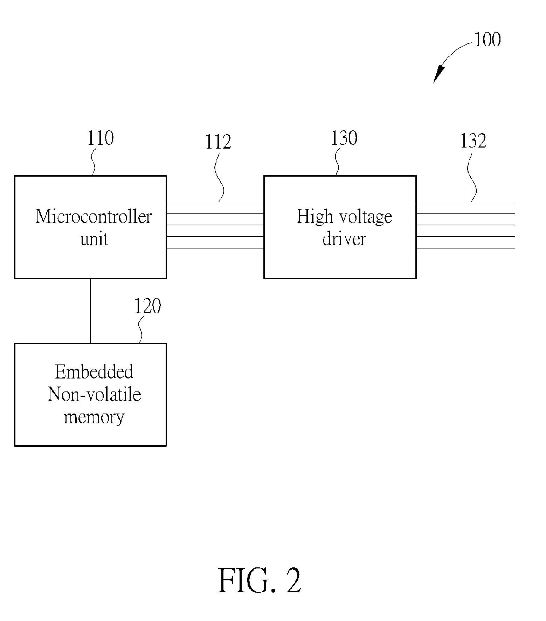

FIG. 2 shows a high voltage power control system 100 according to one embodiment of the present invention. The high voltage power control system 100 comprises a micro controller unit 110, an embedded non-volatile memory 120, and a high voltage driver 130. The microcontroller unit 110 is configured to control high voltage outputs 132 of the high voltage power control system 100. The embedded non-volatile memory 120 and the high voltage driver 130 are electrically connected to the micro controller unit 110. In one embodiment, the micro controller unit 110 can monitor the system environment and output the appropriate control signals 112 according to system parameter settings, a predetermined algorithm program, identification information, or security information. The required program codes, parameter settings, identification or security information for operations of the micro controller unit can thus be stored in the embedded non-volatile memory 120. Once the micro controller unit 110 has finished the calculation, the micro controller unit 110 will output the control signals 112. The high voltage driver 130 will receive the control signals 112 and output the high voltage outputs 132 of the high voltage power control system 100 by driving the voltage levels of the control signals 112 to higher voltage levels.

Since the micro controller unit 110 is designed for logical signal operations of low voltage, the micro controller unit 110 at least comprises low voltage devices that support low voltage operations such as 1.2V, 1.5V or 1.8V. In another embodiment, the micro controller unit 110 may also need to support medium voltage operations such as 3V to 4V or 5V to 6V. In this case, the micro controller unit 110 may further comprise medium voltage devices that are able to support medium voltage operations. Since the logic process here is referring to the manufacturing processes supporting low to medium rails such as 1.2V, 1.5V, 1.8V, 3.3V, 5V, and voltage range within 6V for common systems, the micro controller unit 110 is compatible with the logic process. Contrarily, a device designed for operations of higher voltage such as 8V, 10V or even higher voltage usually requires a high voltage process. The thicker gate oxide and the lower doping concentration of the source and drain of the high voltage process make the device capable of enduring high voltage operations comparing to the logic process. Since the embedded non-volatile memory 120 also needs to support high voltage operations, the embedded non-volatile memory may comprise low voltage devices, medium voltage devices, and devices that can support high voltage operations. Similarly, the high voltage driver 130 may comprise medium voltage devices and devices that can support high voltage operations. United States Patent Number 8,373,485, included herein by reference, teaches a voltage level shifting apparatus capable of operating in either a high-voltage mode or a low-voltage mode. Therefore, with the similar approaches taught by United States patent number 8,373,485, the embedded non-volatile memory 120 can also be formed by the same logic process as the micro controller unit 110, while the embedded non-volatile memory 120 can still endure the high voltage operations.

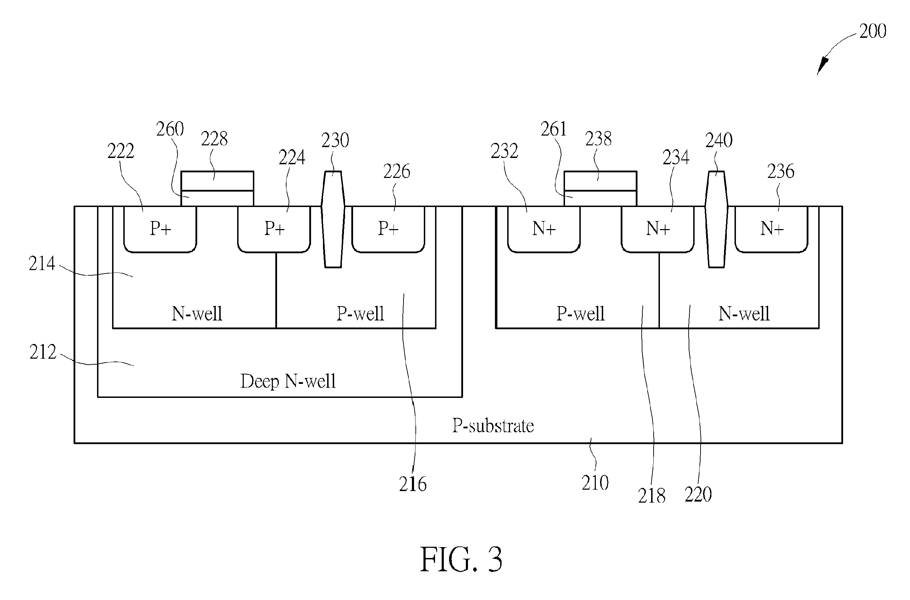

FIG. 3 shows a laterally diffused transistor structure 200 according to one embodiment of the present invention. The laterally diffused transistor structure 200 is formed by the logic process, but can endure high voltage. The laterally diffused transistor structure 200 comprises a P-substrate 210, a deep N-well 212, a first N-well 214 disposed in the deep N-well 212, a first P-well 216 disposed adjacent to the first N-well 214 in the deep N-well 212, a second P-well 218 disposed in the P-substrate 210, and a second N-well 220 disposed adjacent to the second P-well 218 in the P-substrate 210. The laterally diffused transistor structure 200 further comprises a first P+ doped region 222 in the first N-well 214, a second P+ doped region 224 in between the first N-well 214 and the first P-well 216, a third P+ doped region 226 in the first P-well 216, a first gate structure 228 disposed between the first and second P+ doped regions 222 and 224, and a shallow trench isolation 230 disposed in the first P-well 216 between the second P+ doped region 224 and the third P+ doped region 226. Therefore, a laterally diffused PMOS transistor is composed of a PMOS transistor for medium voltage operations and the first special designed drain formed by the third P+ doped region 226 and the second P-well 216. Although typically the breakdown voltage of the PMOS transistor for medium voltage operations may be 3V to 4V or 5V to 6V, the laterally diffused PMOS may endure the high voltage operation by the aid of the first special designed drain. Since the first P-well 216 has a lower doping density than the P+ doped regions 222, 224, 226, the third P+ doped region 226 and the first P-well 216 is equivalent to a divider resistor when applying a high voltage source to the third P+ doped region. Thus, by using the first special designed drain, the stress of high voltage endured by the laterally diffused PMOS can be reduced by the equivalent divider resistor and the laterally diffused PMOS transistor can be used for high voltage operations.

In addition, the laterally diffused transistor structure 200 further comprises a fourth N+ doped region 232 in the second P-well 218, a fifth N+ doped region 234 in-between the second P-well 218 and the second N-well 220, a sixth N+ doped region 236 in the second N-well 220, a second gate structure 238 disposed between the fourth and fifth N+ doped regions 232 and 234, and the shallow trench isolation 240 disposed in the second N-well 220 between the fifth N+ doped region 234 and the sixth N+ doped region 236. Therefore, a laterally diffused NMOS transistor is composed of a NMOS transistor for medium voltage operations and the second special designed drain formed by the sixth N+ doped region 236 and the second N-well 220. Although typically the breakdown voltage of the NMOS transistor for medium voltage operations may be 3V to 4V or 5V to 6V, the laterally diffused NMOS may endure the high voltage operation by the aid of the second special designed drain. Since the second N-well 220 has a lower doping density than the N+ doped regions 232, 234, 236, the sixth N+ doped region 236 and the second N-well 220is equivalent to a divider resistor when applying a high voltage source to the sixth N+ doped region 236. Thus, the stress of high voltage endured by the laterally diffused NMOS can be reduced by the equivalent divider resistor and the laterally diffused NMOS transistor can be used for high voltage operations.

In one embodiment, the laterally diffused transistor structure 200 is formed by the generic 3-4V logic process and can be operated with high voltage from 3V to 12V. In this case, the thickness of the gate oxide 260, 261 of the first or second gate structure 228 or 238 can be in the range from 60Å to 80Å and is much less than a thickness of a gate oxide used in a high voltage process, which can be greater than 250Å. In another embodiment, the laterally diffused transistor structure 200 can be formed by the generic 5-6V logic process and can be operated with high voltage from 8V to 18V. In this case, the thickness of the gate oxide 260, 261 of the first or second gate structure 228 or 238 may be in the range from 120Å to 140Å and is still less than the thickness of the gate oxide used in the high voltage process. Furthermore, the aforementioned laterally diffused transistor structure is to show a better embodiment of the present invention and is not to limit the present invention.

By adopting the aforementioned laterally diffused transistor structure, the embedded non-volatile memory 120 and the high voltage driver 130 can also be compatible with the logic process while supporting operations of high voltage. Consequently, all the components in the high voltage power control system 100 may be compatible with the same logic process and can thus save the extra cost of manufacturing and integration caused by using the high voltage process.

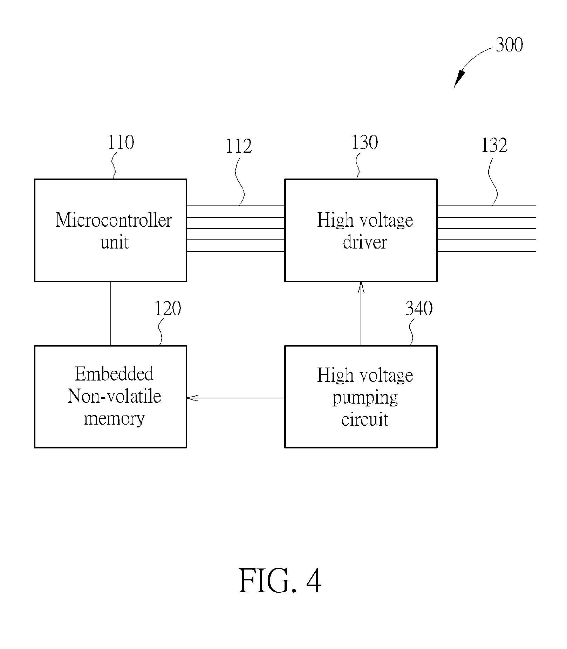

FIG. 4 shows the high voltage power control system 300 according to another embodiment of the present invention. The high voltage power control system 300 has the same structure as the high voltage power control system 100, but further comprises an adjustable high voltage pumping circuit 340. The adjustable high voltage pumping circuit 340 is configured to provide power supply to the high voltage driver 130. In another embodiment, the high voltage pumping circuit 340 can provide power supply to the embedded non-volatile memory 120 if needed. Since the power supply may include high voltage rails, the aforementioned lateral diffuse transistor structure can also be adopted in the adjustable high voltage pumping circuit 340 so the adjustable high voltage pumping circuit 340 can also be formed by the same logic process. However, the high voltage pumping circuit 340 is not always necessary; for example, if a high voltage source is available in the system, then the high voltage pumping circuit 340 can be replaced by the high voltage source directly.

In summary, with the high voltage power control system according to the embodiments of the present invention, the high voltage power control system can be developed and manufactured using a same logic process without extra masks and costs. In addition, since each part of the high voltage power control system is compatible with the logic process, the integration becomes easier and the yield rate of manufacture can also be improved.

## Claims

1. A high voltage power control system (100, 300) compatible with a logic process, the high voltage power control system (100, 300) **characterized by**:
a microcontroller unit (110) configured to control high voltage outputs of the high voltage power control system (100, 300), and comprising at least low voltage devices;
an embedded non-volatile memory (120) electrically connected to the microcontroller (110), and comprising low voltage devices, medium voltage devices and laterally diffused transistors (200); and
a high voltage driver (130) electrically connected to the micro controller (110), configured to output the high voltage outputs (132) of the high voltage power control system (100, 300), and at least comprising medium voltage devices and laterally diffused transistors (200).

2. The high voltage power control system (300) of claim 1, further **characterized by**:
an adjustable high voltage pumping circuit (340) configured to provide power supply to the high voltage driver (130), and comprising at least medium voltage devices and laterally diffused transistors (200).

3. The high voltage power control system (300) of claims 1 or 2, further **characterized by** a high voltage source (340) configured to supply power to the high voltage driver (130) and the embedded non-volatile memory (120).

4. The high voltage power control system (100, 300) of any of claims 1-3, further **characterized in that** a gate oxide (260, 261) of the laterally diffused transistor (200) has a thickness which is less than a thickness of a gate oxide of a transistor (T1, T2, T3, T4, T5, T6) formed by a high voltage process.

5. The high voltage power control system (100, 300) of any of claims 1-4, further **characterized in that** the embedded non-volatile memory (120) is configured to store program codes, parameter settings, identification or security information for operations of the micro controller unit (110).

6. The high voltage power control system of (100, 300) of any of claims 1-5 further **characterized in that** the medium voltage devices support operations of 3V to 4V voltage.

7. The high voltage power control system (100, 300) of any of claims 1-6, further **characterized in that** the low voltage devices support operations of voltage up to 1.2V or 1.8V.

8. The high voltage power control system (100, 300) of any of claims 1-6, further **characterized in that** the low voltage devices support operations of voltage up to 1.8V.

9. The high voltage power control system (100, 300) of any of claims 1-8, further **characterized in that** the laterally diffused transistors (200) support operations of 3V to 12V voltage.

10. The high voltage power control system (100, 300) of any of claims 1-5, further **characterized in that** the medium voltage devices support operations of 5V to 6V voltage.

11. The high voltage power control system (100, 300) of any of claims 1-5 and 10, further **characterized in that** the low voltage devices support operations of voltage up to 1.5V.

12. The high voltage power control system (100, 300) of any of claims 1-5 and 10, further **characterized in that** the low voltage devices support operations of voltage up to 1.8V.

13. The high voltage power control system (100, 300) of any of claims 1-5 and 10-12, further **characterized in that** the laterally diffused transistors (200) support operations with voltage of 8V to 18V.
